# EUROPÄISCHE PATENTSCHRIFT

(11) **EP 0 684 696 B1**
(45) Veröffentlichungstag und Bekanntmachung des Hinweises auf die Patenterteilung: **17.10.2001**
(21) Anmeldenummer: 95201098.1
(22) Anmeldetag: 28.04.1995
(51) Int. Cl.: H03C 3/09

(54) **Frequenz-Modulator mit einer Abgleichschaltung**
Frequency modulator with a trimming circuit
Modulateur de fréquence avec un circuit d'ajustage

(30) Priorität: 06.05.1994 DE 4415989
(43) Veröffentlichungstag der Anmeldung: 29.11.1995
(73) Patentinhaber: Philips Corporate Intellectual Property GmbH, 52064 Aachen (DE); Koninklijke Philips Electronics N.V., 5621 BA Eindhoven (NL)
(72) Erfinder: Ernst, Holger, D-20097 Hamburg (DE); Moll, Holger, D-20097 Hamburg (DE)
(74) Vertreter: von Laue, Hanns-Ulrich, Dipl.-Ing.

(56) Entgegenhaltungen:
- EP-A- 0 447 210
- PATENT ABSTRACTS OF JAPAN vol. 6, no. 200 (E-135), 9.Oktober 1982 & JP-A-57 109422 (TOKYO SHIBAURA DENKI KK), 7.Juli 1982,

## Beschreibung

Die Erfindung betrifft einen Frequenz-Modulator mit einer Abgleichschaltung, mittels dessen ein diesem zugeführtes Leuchtdichte-Signal eines Synchronisations-Impulse aufweisenden Farbfernsehsignals frequenzmoduliert wird, dessen Farbsignal einem Träger aufmoduliert ist, für den eine Referenzfrequenz vorgesehen ist, wobei in der Abgleichschaltung eine Kapazität vorgesehen ist, welche in Abhängigkeit der Periodendauer des Modulator-Ausgangssignals und in Abhängigkeit der Periodendauer der Referenzfrequenz des Farbträgers geladen bzw. entladen wird.

Derartige Frequenz-Modulatoren sind in Videorekordern vorgesehen, in denen das Leuchtdichtesignal eines Farbfernsehsignals mittels des Frequenzmodulators in ein frequenzmoduliertes Signal umgesetzt und in dieser Form aufgezeichnet wird. Dabei sind in den Spezifikationen der Aufzeichnungsnorm meist die Frequenzen und der Hub für diese Frequenzmodulation genau festgelegt. Damit ein Austausch derartig aufgezeichneter Bänder zwischen verschiedenen Geräten möglich ist, müssen diese genau eingehalten werden. Die Toleranzen dieser Frequenzen sind so eng, daß sie in einer integrierten Schaltung nicht ohne besondere Maßnahmen erfüllt werden können. Beispielsweise für die VHS-Norm ist für die Momentanfrequenz während der Synchronisations-Impulse 3,8 MHz und für einen weißen Bildinhalt 4,8 MHz vorgesehen.

In bekannten Schaltungskonzepten sind daher zwei Abgleichpunkte vorgesehen, nämlich um die Frequenz für die Synchronisations-Impulse und den weißen Inhalt einzeln einstellen zu können. Dieser Abgleich kann ggf. während der IC-Fabrikation auf den Chip erfolgen. Dies hat jedoch den Nachteil, daß der Abgleich der Schaltung nicht in ihrer späteren Umgebung im Gerät mit den dort herrschenden Temperatur-, Spannungs- und weiteren Einflüssen vorgenommen werden kann und daher im Endeffekt nicht sehr genau ist.

Aus den Patent Abstracts of Japan vol. 6, no. 200 (E-135), 9. Oktober 1982 & JP-A-57 109422 (TOKYO SHIBAURA DENKI KK), 7. Juli 1982, ist ein Frequenzmodulator mit einer Abgleichschaltung bekannt, bei dem eine Kapazität in Abhängigkeit der Periodendauer des Modulator-Ausgangssignals bzw. in Abhängigkeit der Periodendauer der Referenzfrequenz des Farbträgers geladen bzw. entladen wird. Dabei wird die Kapazität in Abhängigkeit der Periodendauer des einen Signals geladen und in Abhängigkeit der Periodendauer des anderen Signals entladen. Durch gegebenenfalls differierende Periodendauern der beiden Signale entsteht somit im Mittel eine höhere oder niedrigere Ladung der Kapazität. In Abhängigkeit der Ladung der Kapazität wiederum wird die Modulator-Frequenz nachgeführt. Diese Schaltung weist den Nachteil auf, daß relativ lange Lade- und Entladezeiten vorgesehen sind und daß eine relativ unsensible Reaktion auf Veränderungen der Periodendauern der beiden Signale stattfindet. Ferner ist keine Einstellung der Steilheit der Spannungs-/Frequenz-Kennlinie des Modulators vorgesehen.

Aus der US 4,918,529 ist eine Abgleichschaltung für einen Modulator bekannt, für deren Arbeitsweise ein gesonderter Impuls in das Fernsehsignal eingestanzt wird, der bestimmte Spannungszustände einnimmt, anhand derer der Abgleich des Modulators vorgenommen wird. Der Nachteil dieser Schaltungsanordnung besteht vor allem darin, daß ein zusätzlicher Impuls erzeugt, eingespeist und nachfolgend bei dem Abgleich identifiziert werden muß.

Es ist Aufgabe der Erfindung, einen Frequenz-Modulator mit einer Abgleichschaltung zu schaffen, welche die Spannungs-/Frequenz-Kennlinie des Motors einstellt und dabei trotz möglichst kurzer Ladezeiten der Kapazität möglichst genau und empfindlich arbeitet.

Diese Aufgabe wird erfindungsgemäß dadurch gelöst, dass in Abhängigkeit des Ladezustands der Kapazität die Steilheit der Spannungs-/Frequenz-Kennlinie des Modulators eingestellt wird, wobei das Verhältnis der Lade- zu den Entladenvorgängen so gewählt ist, dass die Ladung der Kapazität im Mittel konstant bleibt, wenn die Modulator-Frequenz gleich einer vorgegebenen Sollfrequenz ist, und zu- bzw. abnimmt, wenn die Modulatorfrequenz während der Synchronisations-Impulse kleiner oder größer als die Sollfrequenz ist,
dass in der Abgleichschaltung Mittel vorgesehen sind, welche während jedes Synchronisations-Impulses des Farbfernsehsignals zwei Impulse erzeugen, von denen ein erster Impuls eine Zeitdauer entsprechend der Zeitdauer einer vorgegeben ersten Anzahl von Perioden der Referenzfrequenz des Farbsignals aufweist und von denen ein zweiter Impuls eine Zeitdauer entsprechend der Zeitdauer einer vorgegeben zweiten Anzahl von Perioden des Modulator-Ausgangssignals aufweist,
dass die erste und die zweite Anzahl so gewählt sind, dass innerhalb des zulässigen Frequenzhubs des FM-Modulators immer der erste oder immer der zweite Impuls länger ist als der andere,
dass während derjenigen Zeiten, in denen der längere Impuls, nicht jedoch der kürzere Impuls auftritt, mittels einer ersten Stromquelle die Kapazität geladen wird,
dass Mittel vorgesehen sind, welche während der Zeitdauer einer vorgegebenen dritten Anzahl von Perioden entweder des Modulator-Signals oder der Referenzfrequenz des Farbträgers mittels einer zweiten Stromquelle die Kapazität entladen,
dass die erste, zweite und dritte Anzahl von Perioden und die Stromquellen so gewählt bzw. ausgelegt sind, dass die Ladung der Kapazität während der Synchronisations-Impulse durch die Stromquellen im Mittel konstant bleibt, wenn die Modulator-Frequenz gleich einer vorgegebenen Sollfrequenz ist, und zu- bzw. abnimmt, wenn die Modulatorfrequenz während der Synchronisations-Impulse kleiner bzw. größer als die Sollfrequenz ist.

Für den erfindungsgemäßen Frequenz-Modulator mit einer Abgleichschaltung ist vorgesehen, daß dessen Eingangsspannungs-/Frequenz-Kennlinie in Abhängigkeit der Spannung eines in der Abgleichschaltung vorgesehenen Kondensators eingestellt wird.

Diese Kapazität wird während jedes Synchronisations-Impulses des Farbfernsehsignals während verschiedener Zeitspannen geladen bzw. entladen. Der nach dem Synchronisations-Impuls verbleibende Ladungswert der Kapazität bestimmt dann nachfolgend die Steilheit des Frequenz-Modulators. Dieser Vorgang wiederholt sich bei jedem Synchronisations-Impuls.

Zur Einstellung dieser Kennlinie werden die Periodendauer einerseits des Modulator-Ausgangssignals und andererseits die Periodendauer der Farbträger-Referenzfrequenz des Farbfernsehsignals herangezogen. Für das Farbfernsehsignal existiert eine eng eingegrenzte Referenzfrequenz, welche infolgedessen konstante und bekannte Periodendauern aufweist. Diese Referenzfrequenz ist in der Farbsignal-Übertragungsnorm festgelegt und wird in einem Farbträger-Burst übertragen, der diese Referenzfrequenz aufweist. Erfindungsgemäß werden nun eine bestimmte Anzahl von Perioden des Modulator-Ausgangssignals und eine bestimmte Anzahl von Perioden des Signals mit Farbträger-Ruhefrequenz dazu herangezogen, während dieser Periodendauern die Kapazität zu laden oder zu entladen. Dabei müssen die Periodendauern, d.h. also die Vielfachen der Perioden dieser beiden Signale einerseits und die Lade- bzw. Entladeströme für den Kondensator so gewählt werden, daß die Modulator-Frequenz auf die Sollfrequenz eingestellt wird. Dazu muß die Ladung der Kapazität konstant bleiben, wenn die Modulatorfrequenz gleich einer vorgegebenen Sollfrequenz ist. Je nach Abhängigkeit der Eingangsspannungs-/Frequenz-Kennlinie muß die Ladung der Kapazität zu- bzw. abnehmen, wenn die Modulatorfrequenz während der Synchronisationsimpulse kleiner bzw. größer als die Sollfrequenz ist.

Im Ergebnis wird also über die Frequenz und damit die Periodendauer einerseits des Modulator-Ausgangssignals und andererseits der Referenzfrequenz des Farbträgers, die konstant ist, die Spannung der Kapazität so eingestellt, daß die Modulator-Kennlinie den gewünschten Verlauf annimmt. Es ist hierzu keinerlei Abgleich erforderlich, da laufend, während jedes Synchronisationsimpulses, quasi ein Vergleich der Frequenzen und damit der Periodendauern dieser beiden Signale vorgenommen wird und über diesen Frequenzvergleich die Ladung der Kapazität und damit die Modulator-Kennlinie eingestellt wird.

Es wird hier die Einstellung der Modulator-Kennlinie nur in einem Punkt, nämlich während der Synchronisations-Impulse vorgenommen. Der Abgleich der Modulatorfrequenz bei einem weißen Signalinhalt des Fernsehsignals ist an sich nicht erforderlich, da das Verhältnis dieser beiden Frequenzen zueinander festliegt und der Frequenz-Modulator bzw. dessen Kennlinie so ausgelegt werden kann, daß dieses Verhältnis sehr genau eingehalten wird. Derartig genau arbeitende Modulatoren sind bereits nach dem Stande der Technik bekannt.

Dabei kann die Abgleichschaltung des Frequenz-Modulators je nach Verschaltung der Kapazität so ausgelegt sein, daß beispielsweise bei den Ladevorgängen die Ladung der Kapazität zu- oder abnimmt, wenn die Modulatorfrequenz während der Synchronisationsimpulse kleiner als die Sollfrequenz ist. Entsprechendes gilt auch für die Entladevorgänge. Entscheidend dabei ist nur, daß dann, wenn die Modulatorfrequenz kleiner als die Sollfrequenz ist, die Ladung der Kapazität in umgekehrter Weise verändert wird als wenn die Modulatorfrequenz größer als die Sollfrequenz ist. Durch die spezielle Erzeugung dieser Impulse wird die Dauer des Ladevorgangs letztlich dadurch bestimmt, wie groß die Differenz der Zeitdauer vorgegebener Anzahlen von Perioden der Ruhefrequenz des Farbträgers bzw. des Ausgangssignals des Modulators ist. Die Dauer des Ladevorganges wird letztlich bestimmt durch die Frequenzdifferenz dieser beiden Signale und damit durch die Abweichung des Modulator-Ausgangssignals während des Synchron-Impulses von der Sollfrequenz. Für den Entladevorgang ist ebenfalls eine bestimmte Anzahl von Perioden eines der beiden Signale vorgesehen. Dabei müssen die verschiedenen Zeitdauern, also insbesondere die Anzahlen der Perioden sowohl des Lade- wie auch des Entladevorganges und die Größe der Ströme für den Lade- bzw. Entladevorgang so ausgelegt sein, daß die Ladung der Kapazität im Mittel konstant bleibt, wenn die Modulator-Frequenz gleich der vorgegebenen Sollfrequenz ist und zu- bzw. abnimmt, wenn die Modulator-Frequenz während der Synchronisations-Impulse kleiner bzw. größer als die Sollfrequenz ist.

Es wird hier letztlich durch ein einfaches Auszählen vorgegebener Anzahlen von Perioden während dieser Perioden vorgegebene Lade- bzw. Entladevorgänge der Kapazität vorgenommen. Weist die Modulator-Ausgangsfrequenz ihre Sollfrequenz auf, so sind diese Impulse bezüglich ihrer Dauer und so ist die Stromstärke beim Laden bzw. Entladen so ausgelegt, daß während des Synchronisations-Impulses und nach Ablauf der Lade- bzw. Entladevorgänge die Ladung der Kapazität konstant bleibt, wenn die Modulator-Frequenz ihre Sollfrequenz hat. Treten von diesem Gleichgewichtszustand Abweichungen auf, weicht beispielsweise die Modulator-Frequenz nach unten ab, so wird ein Ladeimpuls kürzer oder länger und die Ladung der Kapazität verändert sich entsprechend. Durch diese Veränderung der Ladung wird dann die Modulator-Kennlinie entsprechend nachgestellt.

Kerngedanke der Erfindung ist also letztlich eine Art Frequenzvergleich der Modulator-Ausgangsfrequenz und der Referenzfrequenz des Farbträgers des Farbfernsehsignals. Durch diesen Frequenzvergleich kann während der Synchonisations-Impulse festgestellt werden, ob die Frequenzdifferenz dieser beiden Signale einem Sollwert entspricht, den die Differenz haben muß, wenn die Modulator-Ausgangsfrequenz ihre Sollfrequenz hat. Ist dies nicht der Fall, werden die Lade- bzw. Entladevorgänge in der Weise gesteuert, daß sich die Ladung der Kapazität verändert und damit die Steilheit der Modulator-Kennlinie. Es wird dann also über die Nachstellung der Modulator-Kennlinie wieder ein stabiler Zustand erreicht, bei dem der Modulator während der Synchronisations-Impulse ein Ausgangssignal mit der Sollfrequenz liefert.

In den weiteren Unteransprüchen sind vorteilhafte Ausgestaltungen der Erfindung angegeben.

Nachfolgend wird anhand der Zeichnung ein Ausführungsbeispiel der Erfindung näher erläutert. Es zeigen:
Fig. 1 ein Blockschaltbild eines erfindungsgemäßen Frequenz-Modulators mit einer Abgleichschaltung,
Fig. 2 ein Zeitdiagramm einiger Signale der Schaltung nach Fig. 1 und
Fig. 3 ein Blockschaltbild eines Videorekorders mit einem Frequenzmodulator mit Abgleichschaltung gemäß Fig. 1.

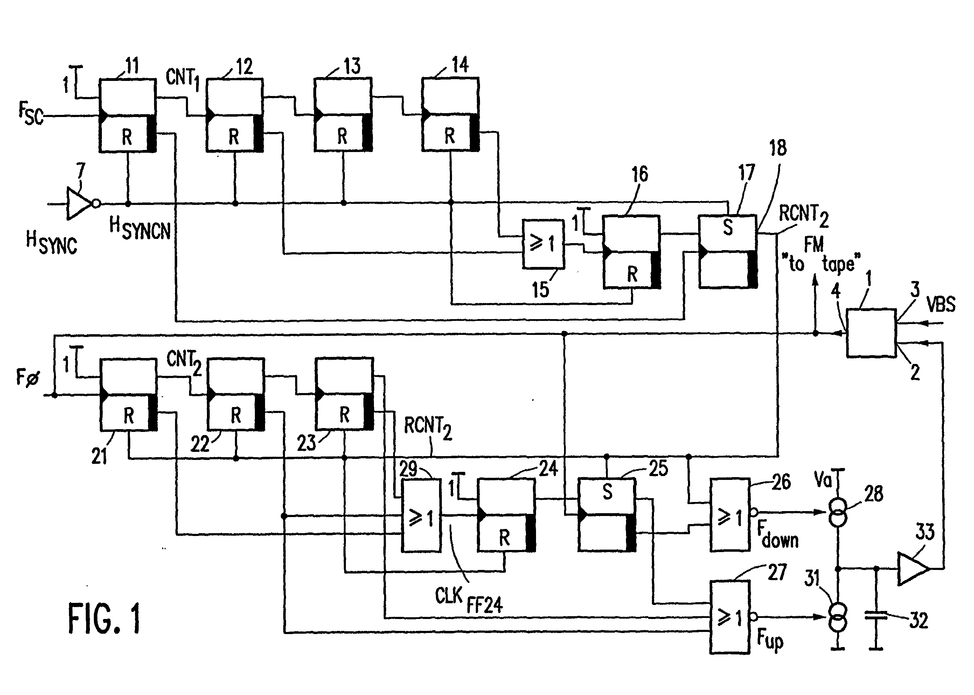

In Fig. 1 ist ein erfindungsgemäßer Frequenz-Modulator 1 mit einer Abgleichschaltung dargestellt.

Die Abgleichschaltung dient dazu, die Steilheit der Eingangsspannungs-/Frequenz-Kennlinie des FM-Modulators 1 einzustellen. Dieser Einstellvorgang kann an dem FM-Modulator 1 mittels eines an seinem Eingang 2 anliegenden Signals vorgenommen werden. Der FM-Modulator 1 weist ferner einen weiteren Eingang 3 auf, an welchem ihm ein Leuchtdichtesignal VBS eines Farbfernsehsignals zugeführt wird. Dieses Leuchtdichtesignal enthält auch die in dem Farbfernsehsignal enthaltenen Synchronisations-Impulse. Der Modulator 1 weist einen Ausgang 4 auf, an welchem er das modulierte Leuchtdichtesignal liefert. In der Fig. 1 wird dieses Signal mit F₀ bezeichnet. Dieses Signal kann beispielsweise in einem Videorekorder auf Band aufgezeichnet werden, was in der Fig. 1 mit der Kennzeichnung "FM to tape" angedeutet ist.

Die Schaltungsanordnung gemäß Fig. 1 weist drei Flipflops 11, 12, 13 und 14 auf, welche sämtlich zu einem ersten Zähler gehören, der in der Figur mit CNT₁ gekennzeichnet ist.

Die Flipflops 11 bis 14 sind, ebenso wie alle weiteren Flipflops in der Schaltung gemäß Fig. 1, negativ flankengetriggert.

Dem Takteingang des ersten Flipflops 11 des Zählers 1 wird ein in der Figur mit F_{SC} gekennzeichnetes Signal zugeführt, bei dem es sich um die Farbträger-Referenzfrequenz des Farbfernsehsignals handelt, dessen Leuchtdichtesignal dem FM-Modulator 1 an seinem Eingang 3 zur Verfügung gestellt wird. In den Farbsignal-Übertragungsnormen ist immer eine Farbträger-Referenzfrequenz vorgesehen. Diese Referenzfrequenz wird im Farbfernsehsignalempfänger mittels eines Farbsignal-Bursts übermittelt, den die Referenzfrequenz aufweist. In der Signalverarbeitung des Empfängers ist im Regelfalle ein Quarzoszillator vorhanden, der über diesen Burst des Farbträgers auf die Referenzfrequenz aufsynchronisiert ist. Für die erfindungsgemäße Schaltungsanordnung kann vorteilhaft das Ausgangssignal dieses auf die Farbträger-Referenzfrequenz aufsynchronisierten Quarzoszillators verwendet werden.

Die Flipflops 11, 12, 13 und 14 sind als Zähler in Reihe geschaltet, d.h. das jeweils der Ausgang des vorherigen Flipflops auf den Takteingang des nachfolgenden geschaltet ist. Dem Rücksetzeingang R jedes dieser Flipflops 11 bis 14 ist das invertierte Synchronisationssignal des Farbfernsehsignals zugeführt, welches in der Fig. mit H_{SYNCN} gekennzeichnet ist.

Die Ausgangssignale der invertierenden Ausgänge der Flipflops 12 und 14 sind auf ein Oder-Gatter 15 geführt, dessen Ausgangssignal dem Takteingang eines Flip-Flops 16 zugeführt, dessen Eingang fest auf Highpegel gesetzt ist. Dem Rücksetzeingang R des Flipflops 16 ist ebenfalls das invertierte horizontale Synchronisationssignal H_{SYNCN} zugeführt.

Der nicht invertierte Ausgang des Flipflops 16 ist auf einen Eingang eines weiteren Flipflops 17 geschaltet, welches mittels des invertierten Ausgangssignals des Flipflops 11 getaktet wird. Das Flipflop 17 weist einen Setzeingang S auf, welchem das Signal H_{SYNCN} zugeführt ist.

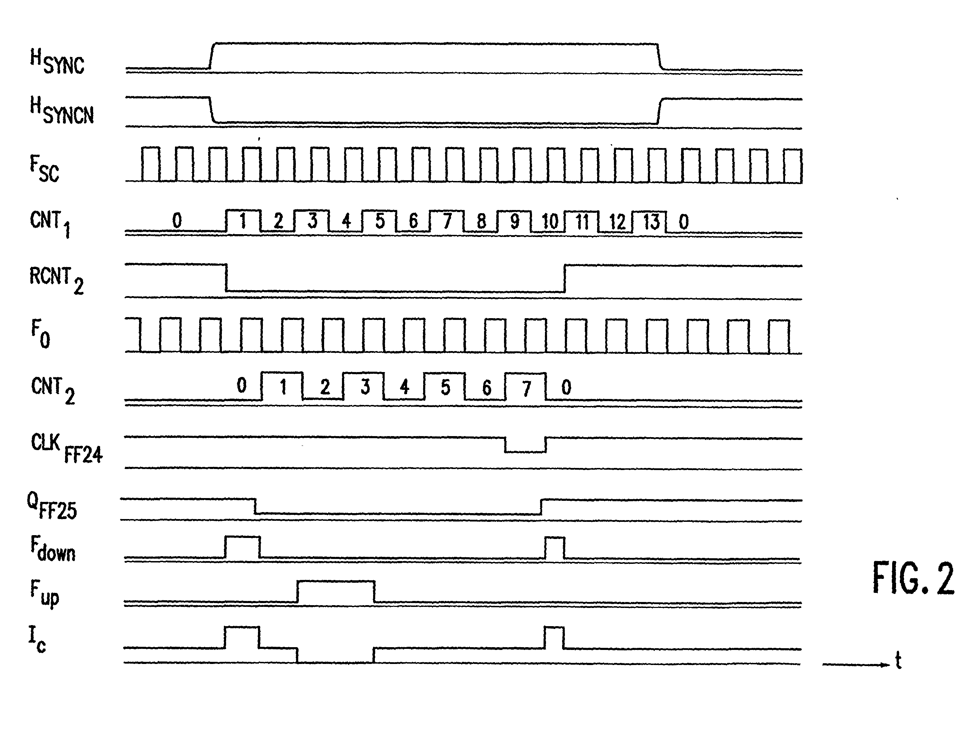

Durch diese Verschaltung des Zählers 1, der aus den Flipflops 11, 12, 13 und 14 und der weiteren Ausdekodierung mittels des Oder-Gatters 15 und der Flipflops 16 und 17 wird am Ausgang 18 des Flipflops 17 ein Ausgangssignal RCNT₂ ausdekodiert, welches nach jeder Negativflanke des Signals H_{SYNCN} einen Impuls einer Breite von 10 Perioden des Farbträgersignals F_{SC} liefert, wobei dieser Impuls mit der nächsten abfallenden Flanke des Signals F_{SC} nach Beginn des Synchronisations-Impulses in dem Signal H_{SYNCN} beginnt. Diese Zusammenhänge werden weiter unten anhand der Zeitdiagramme in Fig. 2 näher erläutert.

Das Ausgangssignal des Flipflops 17, das in der Fig. mit RCNT₂ gekennzeichnet ist, wird Reseteingängen dreier weiterer Flipflops 21, 22 und 23 zugeführt, welche gemeinsam einen zweiten Zähler bilden, der in der Fig. mit CNT₂ gekennzeichnet ist.

Dem Takteingang des Flipflops 21 dieses Zählers ist das Ausgangssignal F₀ des FM-Modulators 1 zugeführt. Der Ausgang des Flipflops 21 ist auf den Takteingang des Flipflops 22 und der Ausgang dieses Flipflops auf dem Takteingang des Flipflops 23 geschaltet.

Es ist ein Oder-Gatter 29 vorgesehen, dessen Eingängen die invertierten Ausgangssignale der Flipflops 21, 22 und 23 zugeführt sind. Das Ausgangssignal dieses Oder-Gatters, das in der Fig. mit CLK_{FF24} gekennzeichnet ist, wird auf den Takteingang eines weiteren Flipflops 24 geführt, dessen Eingang fest auf Highpegel gesetzt ist und dessen Reseteingang mit dem Signal RCNT₂ gespeist wird. Der nicht invertierende Ausgang dieses Flipflops ist auf einen Eingang eines Flipflops 25 geschaltet, das mittels des Ausgangsignals F₀ des FM-Modulators 1 getaktet wird. Ein Setzeingang S des Flipflops 25 ist mit dem Ausgangssignal RCNT₂ des Flipflops 17 beschaltet.

Es ist ein Oder-Gatter 26 vorgesehen, welches einen invertierenden Ausgang aufweist, welcher ein in der Fig. mit F0_{down} gekennzeichnetes Signal liefert. Ferner ist ein Oder-Gatter 27 vorgesehen, welches ebenfalls ein invertiertes Ausgangssignal liefert, das in der Fig. mit F0ᵤₚ bezeichnet ist.

Den beiden Eingängen des Oder-Gatters 26 ist das invertierte Ausgangssignal des Flipflops 25 sowie das Ausgangssignal RCNT₂ des Flipflops 17 zugeführt.

Dem Oder-Gatter 27 wird das nicht invertierte Ausgangssignal des Flipflops 25, das nicht invertierte Ausgangssignal des Flipflops 23 des zweiten Zählers sowie das invertierte Ausgangssignal des Flipflops 22 dieses Zählers zugeführt.

Die Oder-Gatter 26 bzw. 27 liefern Ausgangssignale, mittels derer Stromquellen 28 bzw. 31 gesteuert werden. Mittels dieser Stromquellen wird eine Kapazität 32 geladen bzw. entladen. Der Ladezustand dieser Kapazität 32 gelangt über einen Operationsverstärker 33 an den Eingang 2 des FM-Modulators 1. In Abhängigkeit des Ladezustandes der Kapazität 32 wird also die Steilheit der Spannungs-/Frequenz-Kennlinie des FM-Modulators 1 gesteuert.

Anhand der Fig. 2, welche Zeitdiagramme einiger Signale der Anordnung gemäß Fig. 1 darstellt, wird nachfolgend die Arbeitsweise der Schaltung gemäß Fig. 1 näher erläutert.

Der erste Zähler CNT₁ mit seinen vier Flipflops 11 bis 14 kann grundsätzlich bis 16 zählen. Das in der Fig. 2 mit H_{SYNC} dargestellte Synchonisationssignal wird mittels des Inverters 7 invertiert, so daß jeder Synchronisations-impuls als negativer Impuls auftaucht. Da dieses invertierte Signal den Reset-Eingängen der Flipflops 11 bis 14 zugeführt ist, kann der erste Zähler nur während eines solchen Impulses zählen. Gezählt wird das Signal F_{SC}, das in Fig. 2 ebenfalls dargestellt ist. In dem Beispielsfall gemäß Fig. 2 ist der Impuls des Signals H_{SYNC} so breit, daß der Zähler bis 13 zählt und dann wieder zurückgesetzt wird.

Mit der ersten negativen Flanke des Signals F_{SC} nach der negativen Flanke des Signals H_{SYNCN} wird das erste Fli pflop 11 des ersten Zählers auf 1 gesetzt und der Zählvorgang beginnt. Gleichzeitig geht das Signal RCNT₂ am Ausgang 18 des Flipflops 17 auf Lowpegel. Infolge der Ausdekodierung durch das Oder-Gatter 15 wird dieser Impuls mit Erreichen des Zählerstandes 11 beendet und das Signal RCNT₂ geht wieder auf Highpegel. Der Impuls des Signales RCNT₂ weist also eine Breite von 10 Perioden des Signals F_{SC} auf, das eine Frequenz entsprechend der Ruhefrequenz des Farbträgers des Farbfernsehsignals aufweist.

Der zweite Zähler CNT₂ ist mit dem Ausgangssignal F₀ des Modulators 1 getaktet. Der Zähler weist nur drei Flipflops auf, kann also maximal von 0 bis 7 zählen. Mittels des Oder-Gatters 29 wird der Zählerstand 7, alsm der höchste Zählerstand, ausdekodiert. Das Flipflop 24 wird mit dieser ausdekodierten 7 getaktet. Dies ist in Fig. 2 mit dem Signal CLK_{FF24} angedeutet. Das Flipflop 24 war vorher durch RCNT₂ zurückgesetzt und wird durch die Flanke des Signals CLK_{FF24} gesetzt. Da am Dateneingang ein High-Signal liegt, ändert sich dieser Zustand erst wieder, wenn das Flipflop durch RCNT₂ zurückgesetzt wird.

Flipflop 25 ist zu Beginn, d.h. nach der High-Low-Flanke des Signals RCNT₂ gesetzt. Mit der ersten darauffolgenden negativen Flanke des Signals F₀ wird es zurückgesetzt. Mit dem Erreichen des Zählerzustandes 7 liegt an seinem Dateneingang ein High-Signal, so daß mit der 8. negativen Flanke des Signals F₀ das Flipflop 25 wieder gesetzt wird.

Damit weist der Impuls des Signals Q_{FF25} eine Breite von 7 Perioden des Ausgangssignals F₀ des Modulators 1 auf. Tritt das Ende des Impulses des Ausgangssignals des Flipflops 17, RCNT₂ vorher auf, so wird Flipflop 25 dann bereits gesetzt und die Breite von 7 Perioden des Ausgangssignals F₀ des Modulators 1 wird nicht erreicht.

Infolge der weiteren Ausdekodierung mittels des Oder-Gatters 26 wird das Signal F_{down} gemäß Fig. 2 erzeugt. Dieses Signal wird in der Weise ausdekodiert, daß F_{down} während eines Impulses H_{SYNCN} dann einen Impuls enthält, wenn ein Impuls im Signal RCNT₂ vorhanden ist, in Q_{FF25} jedoch nicht, wenn also RCNT₂ Lowpegel hat, Q_{FF25} jedoch Highpegel. In dem Beispielsfall gemäß Fig. 2 ist dies während zweier Zeitspannen der Fall, in denen das Signal F_{down} dann zwei Impulse enthält. Je nach Maß der Frequenzdifferenz zwischen F_{SC} und F₀ und damit der unterschiedlichen Dauer der 10 Perioden des Signals F_{SC} und der 7 Perioden des Signals CNT₂ sind diese Impulse länger oder kürzer. Es ist deutlich, daß in der Schaltungsanordnung gemäß Fig. 1 damit die Stromquelle 28 je nach Periodendauer des Signals F₀ im Verhältnis zu Signal F_{SC} kürzer oder länger angesteuert wird, so daß die Ladung der Kapazität 32 entsprechend beeinflußt wird. Der Entladevorgang über die Stromquelle 31 wird in Abhängigkeit des Signals Fᵤₚ vorgenommen. Das Signal Fᵤₚ ist so mittels des Oder-Gatters 27 aus den Zählerständen des zweiten Zählers ausdekodiert, daß es eine Breite von 2 Perioden des Signales F₀ hat. Während dieser Zeitspanne wird über die Stromquelle 31 die Kapazität 32 in der Anordnung gemäß Fig. 1 entladen. Diese Zeitspannen, nämlich die 10 Perioden des Signals F_{SC} minus die 7 Perioden des Signals F₀ einerseits und die Entladezeit von 2 Perioden des Signals F₀ andererseits sowie die Größe der Ströme der Stromquellen 28 und 31 sind so ausgelegt, daß, wenn das Signal F₀ seine Sollfrequenz aufweist, der Ladungswert der Kapazität 32 im Mittel erhalten bleibt. Weist jedoch das Signal F₀ eine zu geringe Frequenz auf, so werden die Impulse des Signals F_{down} länger. Dies bedeutet, daß die Stromquelle 28 während längerer Zeitspannen innerhalb eines jeden Synchronisations-Impulses eingeschaltet ist, so daß die Ladung der Kapazität 32 im Mittel ansteigt. Über den Steuereingang 2 des Modulators 1 wird die Steilheit von dessen Spannungs-/Frequenz-Kennlinie entsprechend korrigiert. Infolge dieser Korrektur sinkt die Frequenz F₀ wieder, so daß wieder der stationäre Zustand erreicht wird. Umgekehrtes gilt, wenn die Frequenz F₀ unter die Sollfrequenz abfällt. Diese Zusammenhänge sind in Fig. 2 in dem Zeitdiagramm F_{down} und Fᵤₚ dargestellt. Das Zeitdiagramm I_{c} zeigt den Lade- bzw. Entladestrom des Kondensators 32.

Dieser Lade- bzw. Entladevorgang der Kapazität 32 wird ausschließlich während eines Synchonisations-Impulses des Signals H_{SYNCN} bzw. H_{SYNC} vorgenommen.

Es ist selbstverständlich auch möglich, andere Periodenwerte als die in diesem Ausführungsbeispiel gewählten vorzusehen. Es muß jedoch immer das Verhältnis der Ladezu den Entladeströmen so sein, daß, wenn das Ausgangssignal des Modulators 1 seine Sollfrequenz aufweist, der Ladezustand der Kapazität 32 im Mittel konstant bleibt.

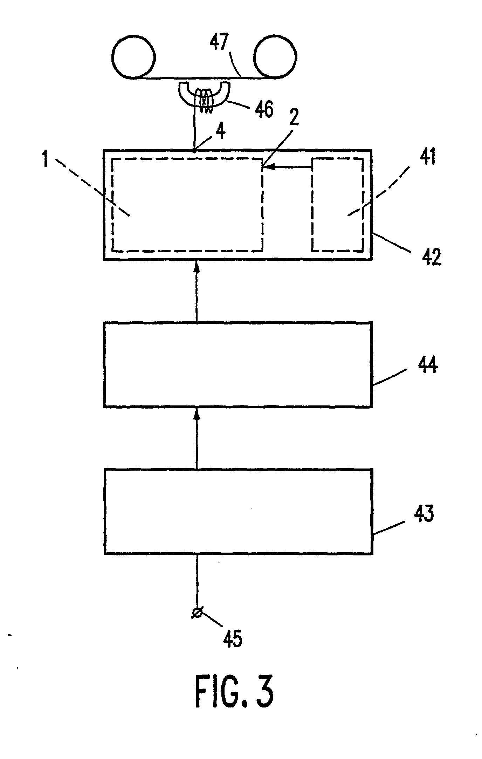

Ein in Fig. 3 schematisch in Form eines Blockschaltbildes dargestellter Videorekorder weist einen HF-Antenneneingang 45 auf, an dem ihm auf verschiedene Frequenzen aufmodulierte Signale beispielsweise von Fernsehsendern geliefert werden. Dem Antenneneingang 45 ist eine Abstimmeinheit 43 nachgeschaltet, welche dazu dient, auf eine Frequenz eines dieser Signale abzustimmen. Das Ausgangssignal der Abstimmeinheit 43 gelangt auf einen HF-Demodulator 44, in dem das empfangene, einem HF-Träger aufmodulierte Bildsignal in Basisbandlage umgesetzt wird, also demoduliert wird. Das Leuchtdichtesignal dieses Fernsehsignals wird in der Anordnung gemäß Fig. 3 der Schaltungseinheit 42, welche einen FM-Modulator 1 sowie eine Abgleichschaltung 41 aufweist, zugeführt. Es handelt sich dabei um das Signal VBS entsprechend Fig. 1.

Ebenfalls entsprechend Fig. 1 ist der Eingang 2 des Modulators 1 dargestellt, an welchem dem Modulator ein Signal zugeführt werden kann, mittels dessen die Steilheit der Eingangsspannungs-/Frequenz-Kennlinie des FM-Modulators 1 eingestellt werden kann. Der FM-Modulator 1 sowie die Abgleichschaltung 41 arbeiten entsprechend der Anordnung gemäß Fig. 1 und 2.

Das Ausgangssignal des FM-Modulators 1 steht an einem Eingang 4 des FM-Modulators 1 bzw. der Schaltungseinheit 41 zur Verfügung. Es gelangt von dort aus zu einem in der Fig. 3 schematisch dargestellten Videokopf 46. Das einer FM-Frequenz aufmodulierte Signal wird mittels des Videokopfes 46 auf ein Magnetband 47 aufgezeichnet, welches mittels eines in der Fig. 3 nicht näher dargestellten Laufwerkes relativ zu dem Videokopf bewegt wird.

## Patentansprüche

1. Frequenz-Modulator (1) mit einer Abgleichschaltung, mittels dessen ein diesem zugeführtes Leuchtdichte-Signal eines Synchronisations-Impulse aufweisenden Farbfernsehsignals frequenzmoduliert wird, dessen Farbsignal einem Träger aufmoduliert ist, für den eine Referenzfrequenz vorgesehen ist, wobei in der Abgleichschaltung (32) eine Kapazität vorgesehen ist, welche in Abhängigkeit der Periodendauer des Modulator-Ausgangssignals und in Abhängigkeit der Periodendauer der Referenzfrequenz des Farbträgers geladen bzw. entladen wird,
**dadurch gekennzeichnet,**
**dass** in Abhängigkeit des Ladezustands der Kapazität die Steilheit der Spannungs/Frequenz-Kennlinie des Modulators (1) eingestellt wird, wobei das Verhältnis der Ladezu den Entladenvorgängen so gewählt ist, dass die Ladung der Kapazität (32) im Mittel konstant bleibt, wenn die Modulator-Frequenz gleich einer vorgegebenen Sollfrequenz ist, und zu- bzw. abnimmt, wenn die Modulatorfrequenz während der Synchronisations-Impulse kleiner oder größer als die Sollfrequenz ist,
**dass** in der Abgleichschaltung Mittel (11,12,13,14,15,16,17;21,22,23,29,24,25) vorgesehen sind, welche während jedes Synchronisations-Impulses des Farbfernsehsignals zwei Impulse erzeugen, von denen ein erster Impuls (RCNT2) eine Zeitdauer entsprechend der Zeitdauer einer vorgegeben ersten Anzahl von Perioden der Referenzfrequenz des Farbsignals aufweist und von denen ein zweiter Impuls (QFF25) eine Zeitdauer entsprechend der Zeitdauer einer vorgegeben zweiten Anzahl von Perioden des Modulator-Ausgangssignals aufweist,
**dass** die erste und die zweite Anzahl so gewählt sind, dass innerhalb des zulässigen Frequenzhubs des FM-Modulators immer der erste (RCNT2) oder immer zweite Impuls (QFF25) länger ist als der andere,
**dass** während derjenigen Zeiten, in denen der längere Impuls, nicht jedoch der kürzere Impuls auftritt, mittels einer ersten Stromquelle (28) die Kapazität (32) geladen wird,
**dass** Mittel vorgesehen sind, welche während der Zeitdauer einer vorgegebenen dritten Anzahl von Perioden entweder des Modulator-Signals oder der Referenzfrequenz des Farbträgers mittels einer zweiten Stromquelle (31) die Kapazität (32) entladen,
**dass** die erste, zweite und dritte Anzahl von Perioden und die Stromquellen (28, 31) so gewählt bzw. ausgelegt sind, dass die Ladung der Kapazität (32) während der Synchronisations-Impulse durch die Stromquellen im Mittel konstant bleibt, wenn die Modulator-Frequenz gleich einer vorgegebenen Sollfrequenz ist, und zu- bzw. abnimmt, wenn die Modulatorfrequenz während der Synchronisations-Impulse kleiner bzw. größer als die Sollfrequenz ist.

2. Frequenz-Modulator nach Anspruch 1,
**dadurch gekennzeichnet, daß** die erste und die zweite Anzahl von Perioden so gewählt sind, daß der erste Impuls innerhalb des zulässigen Frequenzhubs des FM-Modulators immer länger als der zweite Impuls ist.

3. Frequenz-Modulator nach Anspruch 1,
**dadurch gekennzeichnet, daß** die erste Anzahl von Perioden zehn und die zweite Anzahl von Perioden sieben beträgt.

4. Frequenz-Modulator nach Anspruch 1,
**dadurch gekennzeichnet, daß** die dritte Anzahl von Perioden zwei Perioden des Modulator-Ausgangssignals beträgt.

5. Frequenz-Modulator nach Anspuch 1,
**dadurch gekennzeichnet, daß** der erste Impuls mit der ersten abfallenden Flanke des Oszillator-Ausgangssignals hinter der Vorderflanke des Synchronisations-Impulses beginnt.

6. Frequenz-Modulator nach Anspruch 1,
**dadurch gekennzeichnet, daß** der zweite Impuls mit der nächsten abfallenden Flanke des Modulator-Ausgangssignals nach Beginn des ersten Impulses beginnt.

7. Frequenz-Modulator nach Anspruch 1,
**dadurch gekennzeichnet, daß** der dritte Impuls mit der nächsten abfallenden Flanke des Modulator-Ausgangssignals nach Beginn des zweiten Impulses beginnt.

8. Videorekorder mit einem Frequenz-Modulator nach einem der Ansprüche 1 bis 7 zur Aufzeichnung des mittels des Frequenz-Modulators modulierten Leuchtdichtesignals auf einen Aufzeichnungsträger.

## Claims

1. A frequency modulator (1) comprising an adjusting circuit, by which frequency modulator a luminance signal applied to this modulator of a color video signal that contains synchronization pulses is frequency modulated, while the chrominance subcarrier of the color video signal is modulated on a carrier for which there is provided a reference frequency, while a capacitor is included in the adjusting circuit (32), which capacitor is charged or discharged, respectively, in dependence on the period of the output signal of the modulator and in dependence on the period of the reference frequency of the chrominance subcarrier,
**characterized**
**in that** the steepness of the voltage/frequency curve of the modulator (1) is set in dependence on the charging state of the capacitor, while the ratio of charging to discharging operations is selected such that the charge of the capacitor (32) remains constant on average if the modulator frequency is equal to a predetermined nominal frequency and increases or decreases, respectively, if the modulator frequency is smaller or larger than the nominal frequency during the synchronization pulses,
**in that** the trimming circuit includes means (11,12,13,14,15,16,17;21,22,23,29,24,25) which generate two pulses during each synchronization pulse of the chrominance subcarrier, of which a first pulse (RCNT2) has a duration that corresponds to the duration of a predefined first number of periods of the reference frequency of the chrominance subcarrier and of which a second pulse (QFF25) has a duration that corresponds to the duration of a predefined second number of periods of the output signal of the modulator,
**in that** the first and the second number are selected such that within the permissible frequency deviation of the FM modulator always the first (RCNT2) or always the second pulse (QFF25) is longer than the other one,
**in that** during the times in which the longer pulse, but not the shorter pulse, occurs, the capacitor (32) is charged by means of a first current source (28),
**in that** means are provided which discharge the capacitor (32) by a second current source (31) during a predefined third number of periods of either the modulator signal or the reference frequency of the chrominance subcarrier,
**in that** the first, second and third number of periods and the current sources (28,31) are selected or arranged so that the charging of the capacitor (32) by the current sources on average remains constant during the synchronization pulses if the modulator frequency is equal to a predefined nominal frequency and increases or decreases, respectively, if the modulator frequency is larger or smaller than the nominal frequency, respectively, during the synchronization pulses.

2. A frequency modulator as claimed in Claim 1,
**characterized**
**in that** the first and the second number of periods are selected so that the first pulse within the permitted frequency deviation of the FM modulator is always longer than the second pulse.

3. A frequency modulator as claimed in Claim 1,
**characterized**
**in that** the first number of periods is ten and the second number of periods is seven.

4. A frequency modulator as claimed in Claim 1,
**characterized**
**in that** the third number of pulses is equal to two periods of the modulator output signal.

5. A frequency modulator as claimed in Claim 1,
**characterized**
**in that** the first pulse commences at a first falling edge of the oscillator output signal after the leading edge of synchronization pulse.

6. A frequency modulator as claimed in Claim 1,
**characterized**
**in that** the second pulse commences at the next falling edge of the modulator output signal after the start of the first pulse.

7. A frequency modulator as claimed in Claim 1,
**characterized**
**in that** the third pulse commences at the next falling edge of the modulator output signal after the start of the second pulse.

8. A video recorder comprising a frequency modulator as claimed in one of the Claims 1 to 7 for recording the luminance signal modulated by the frequency modulator on a record carrier.

## Revendications

1. Modulateur de fréquence (1) avec un circuit d'ajustage à l'aide duquel un signal de luminance amené à celui-ci d'un signal de télévision couleur présentant des impulsions de synchronisation est modulé quant à sa fréquence, dont le signal couleur est modulé sur une porteuse pour laquelle il est prévu une fréquence de référence, une capacité qui est chargée ou déchargée en fonction de la durée de période du signal de sortie du modulateur et en fonction de la durée de période de la fréquence de référence de la porteuse couleur étant prévue dans le
circuit d'ajustage (32),
**caractérisé en ce**
**qu'**en fonction de l'état de charge de la capacité, la pente de la caractéristique tension/fréquence du modulateur (1) est réglée, le rapport entre les processus de charge et de décharge étant sélectionné de telle sorte que la charge de la capacité (32) reste en moyenne constante lorsque la fréquence du modulateur est égale à une fréquence de consigne préalablement déterminée et augmente ou diminue lorsque la fréquence du modulateur pendant les impulsions de synchronisation est inférieure ou supérieure à la fréquence de consigne,
qu'il est prévu dans le circuit d'ajustage des moyens (11, 12, 13, 14, 15, 16, 17; 21, 22, 23, 29, 24, 25) qui, pendant chaque impulsion de synchronisation du signal de télévision couleur, produisent deux impulsions dont une première impulsion (RCNT₂) présente une durée correspondant à la durée d'un premier nombre préalablement déterminé de périodes de la fréquence de référence du signal couleur et dont une deuxième impulsion (Q_{FF25}) présente une durée correspondant à la durée d'un deuxième nombre préalablement déterminé de périodes du signal de sortie du modulateur,
que les premier et deuxième nombres sont choisis de telle sorte que, dans l'amplitude de fréquence autorisée du modulateur FM, c'est toujours la première (RCNT₂) ou toujours la deuxième (Q_{FF25}) impulsion qui est plus longue que l'autre,
que, pendant les périodes durant lesquelles l'impulsion la plus longue et non la plus courte se produit, la capacité (32) est chargée à l'aide d'une première source de courant (28), qu'il est prévu des moyens qui, pendant la durée d'un troisième nombre préalablement déterminé de périodes, soit du signal de modulateur, soit de la fréquence de référence de la porteuse couleur, la capacité (32) est déchargée à l'aide d'une deuxième source de courant (31),
que les premier, deuxième et troisième nombres de périodes et les sources de courant (28, 31) sont choisis ou conçus de telle sorte que la charge de la capacité (32) pendant les impulsions de synchronisation par les sources de courant reste en moyenne constante lorsque la fréquence du modulateur est égale à une fréquence de consigne préalablement déterminée et augmente ou diminue lorsque la fréquence du modulateur est inférieure ou supérieure à la fréquence de consigne pendant les impulsions de synchronisation.

2. Modulateur de fréquence selon la revendication 1,
**caractérisé en ce que** les premier et deuxième nombres de périodes sont choisis de telle sorte que la première impulsion est toujours plus longue que la deuxième impulsion dans la gamme de fréquences autorisée du modulateur FM.

3. Modulateur de fréquence selon la revendication 1,
**caractérisé en ce que** le premier nombre de périodes s'élève à dix et le deuxième nombre de périodes s'élève à sept.

4. Modulateur de fréquence selon la revendication 1,
**caractérisé en ce que** le troisième nombre de périodes s'élève à deux périodes du signal de sortie du modulateur.

5. Modulateur de fréquence selon la revendication 1,
**caractérisé en ce que** la première impulsion avec le premier flanc descendant du signal de sortie de l'oscillateur commence derrière le flanc d'attaque de l'impulsion de synchronisation.

6. Modulateur de fréquence selon la revendication 1,
**caractérisé en ce que** la deuxième impulsion commence au flanc descendant suivant du signal de sortie du modulateur après le début de la première impulsion.

7. Modulateur de fréquence selon la revendication 1,
**caractérisé en ce que** la troisième impulsion commence au flanc descendant suivant du signal de sortie du modulateur après le début de la deuxième impulsion.

8. Magnétoscope avec un modulateur de fréquence selon l'une des revendications 1 à 7 en vue de l'enregistrement du signal de luminance modulé à l'aide du modulateur de fréquence sur un support d'enregistrement.
